(19) Europäisches Patentamt / European Patent Office / Office européen des brevets

(11) **EP 2 851 961 A2**

(12) **EUROPEAN PATENT APPLICATION**

(43) Date of publication:
**25.03.2015 Bulletin 2015/13**

(51) Int Cl.:
***H01L 31/032*** (2006.01)

(21) Application number: **14182811.1**

(22) Date of filing: **29.08.2014**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**

(30) Priority: **20.09.2013 JP 2013196115**

(71) Applicant: **Kabushiki Kaisha Toshiba**
**Tokyo 105-8001 (JP)**

(72) Inventors:
- **Hiraga, Hiroki**
  **Tokyo, 105-8001 (JP)**
- **Nakagawa, Naoyuki**
  **Tokyo, 105-8001 (JP)**

- **Shibasaki, Soichiro**
  **Tokyo, 105-8001 (JP)**
- **Yamazaki, Mutsuki**
  **Tokyo, 105-8001 (JP)**
- **Yamamoto, Kazushige**
  **Tokyo, 105-8001 (JP)**
- **Sakurada, Shinya**
  **Tokyo, 105-8001 (JP)**
- **Inaba, Michihiko**
  **Tokyo, 105-8001 (JP)**

(74) Representative: **Hoffmann Eitle**
**Patent- und Rechtsanwälte PartmbB**
**Arabellastraße 30**
**81925 München (DE)**

(54) **Method for manufacturing photoelectric conversion device**

(57) A method for manufacturing a photoelectric conversion device of an embodiment includes forming, on a first electrode (2), a photoelectric conversion layer (3) comprising at least oen of a chalcopyrite compound, a stannite compound, and a kesterite compound. The forming of the photoelectric conversion layer includes forming a photoelectric conversion layer precursor comprising at least onecompound semiconductor of a chalcopyrite compound, a stannite compound, and a kesterite compound on the first electrode (2). The forming of the photoelectric conversion layer includes immersing the precursor in a liquid including at least one of Group IIa and Group IIb elements at 0°C to 60°C, after forming of the photoelectric conversion layer precursor. The compound semiconductor on a side of the first electrode is at least either amorphous or larger in average crystal grain size than the compound semiconductor on an opposite side of the first electrode (2).

Fig.1

**Description**

CROSS-REFERENCE TO RELATED APPLICATION

This application is based upon and claims the benefit of priority from Japanese Patent Application No. 2013-196115, filed on September 20, 2013; the entire contents of which are incorporated herein by reference.

FIELD

Embodiments described herein relate to a method for manufacturing a photoelectric conversion device.

BACKGROUND

Compound photoelectric conversion devices have been developed which use a semiconductor thin film as a photoelectric conversion layer. In particular, thin-film photoelectric conversion devices including, as a photoelectric conversion layer, a p-type semiconductor layer which has a chalcopyrite structure are high in conversion efficiency, and expected as energy sources for the next generation. Specifically, thin-film photoelectric conversion devices including, as a photoelectric conversion layer, $Cu(In,Al,Ga)(Se,S)_2$ composed of a Cu-In-Ga-Se(S) achieve high conversion efficiency.

In general, thin-film photoelectric conversion devices including, as a photoelectric conversion layer, a compound semiconductor layer composed of Cu-In-Ga-Se (hereinafter, referred to as "CIGS", if necessary) have a structure of a molybdenum lower electrode, a p-type compound semiconductor layer, an n-type compound semiconductor layer, a transparent electrode layer, an upper electrode, and an anti-reflection film stacked on blue sheet glass to serve as a substrate. The conversion efficiency $\eta$ is expressed by

$$\eta \ = \ Voc \cdot Jsc \cdot FF/P \cdot 100$$

wherein Voc is an open circuit voltage, Jsc is a short-circuit current density, FF is a power factor, and P is an incident power density. As is clear from the foregoing, the conversion efficiency is increased as the open circuit voltage, short-circuit current, and power factor are each increased.

In the preparation of the n-type compound semiconductor layer, p/n homojunction can be formed by imparting n-type conductivity to a p-type semiconductor layer through doping. The homojunction can inhibit the generation of a defect level at a p/n interface, which is found in the case of heterojunction, resolve band offset produced between heterogenous substances, and thus improve the conversion efficiency. For imparting n-type conductivity to a p-type semiconductor, a solution process is common in which the p-type semiconductor is immersed in a dopant solution.

The prior doping for imparting n-type conductivity to homojunction CIGS photoelectric conversion layers is a liquid-phase process at high temperature, which has no choice but to lower the solution concentration for the prevention of precipitate, and causes damage to the CIGS layer due to processing at high temperature, thereby causing a decrease in efficiency. While the surface of the CIGS layer is doped with a Group II element to form pn junction, the process includes a step of depositing high-resistance zinc oxide as the subsequent step, which is carried out at a high temperature of 55°C to 90°C for 10 minutes to 60 minutes, and thus, damage to the photoelectric conversion layer is unavoidable. In fact, the cell conversion efficiency is 13.9% on average, which is lower than those currently manufactured and distributed as modules. Furthermore, the step of depositing high-resistance zinc oxide requires large-size bath equipment, and requires a large amount of waste liquid and a cleaning step once zinc oxide is deposited in the bath, thus also has problems such as an increase in process cost.

BRIEF DESCRIPTION OF THE DRAWINGS

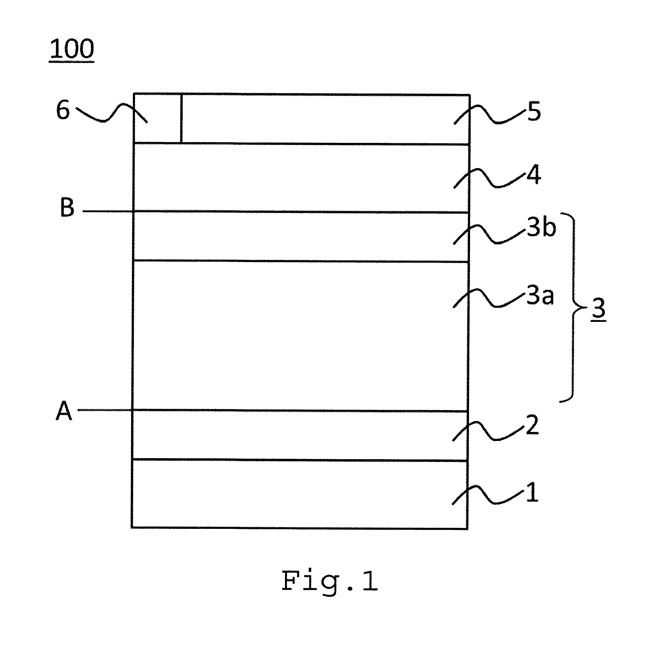

Fig. 1 is a cross-sectional conceptual diagram of a photoelectric conversion device according to an embodiment.

DETAILED DESCRIPTION

A method for manufacturing a photoelectric conversion device of an embodiment includes forming, on a first electrode, a photoelectric conversion layer comprising at least one of a chalcopyrite compound, a stannite compound, and a kesterite compound. The forming of the photoelectric conversion layer includes forming a photoelectric conversion layer precursor comprising at least one compound semiconductor of a chalcopyrite compound, a stannite compound, and a kesterite compound on the first electrode. The forming of the photoelectric conversion layer includes immersing the precursor in a liquid including at least one of Group IIa and Group IIb elements at 0°C to 60°C, after forming of the photoelectric conversion layer precursor. The compound semiconductor on a side of the first electrode is at least either amorphous or larger in average crystal grain size than the compound semiconductor on an opposite side of the first electrode.

Embodiments will be described in detail below with reference to the drawings. In an embodiment, a method for manufacturing a photoelectric conversion device includes a method for manufacturing a photoelectric conversion device, which preferably at least including: forming, on a first electrode, a photoelectric conversion layer including at least one of a chalcopyrite compound, a stannite compound, and a kesterite compound, where the step of forming the photoelectric conversion layer includes a photoelectric conversion layer precursor forming step of forming a photoelectric conversion layer precursor, the precursor including at least one compound semiconductor of a chalcopyrite compound, a stannite compound, and a kesterite compound, and the compound semiconductor on the first electrode is at least either amorphous or larger in average crystal grain size than on the side opposite to the first electrode in the photoelectric conversion layer precursor obtained in the photoelectric conversion layer precursor forming step; and an immersion step of immersing the photoelectric conversion layer precursor formed on the first electrode in a liquid including at least one of Group IIa and Group IIb elements at 0°C to 60°C, after the photoelectric conversion layer precursor forming step.

(Photoelectric conversion device)

FIG. 1 is a schematic diagram showing a photoelectric conversion device 100 according to an embodiment. The photoelectric conversion device 100 is a thin-film photoelectric conversion device including a substrate 1, a lower electrode (first electrode) 2 formed on the substrate 1, a photoelectric conversion layer 3 formed on the lower electrode 2, a transparent electrode (second electrode) 4 formed on the photoelectric conversion layer 3, and an upper electrode 5 and an anti-reflection film 6 formed on the transparent electrode 4. Specific examples of the photoelectric conversion device 100 include solar cells. The solar cells include, for example, solar cell modules which have photoelectric conversion devices used for cells connected in series or in parallel. As long as it is operable as photoelectric conversion devices or solar cells, substrates, films, etc., for photoelectric conversion devices can be omitted which are described according to an embodiment, and new layers can be introduced.

(Substrate)

In an embodiment, blue sheet glass is desirably used as the substrate 1, while a sheet of metal such as stainless steel, Ti or Cr, or a resin such as polyimide can be also used as the substrate 1.

(Lower electrode)

In an embodiment, the lower electrode 2, which is an electrode of the photoelectric conversion device, is a metal film formed on the substrate 1. A film of electrically conductive metal such as Mo or W can be used as the lower electrode 2. In particular, a Mo film is desirably used for the lower electrode 2. The lower electrode 2 can be formed as a film by sputtering or other techniques onto the substrate 1. The lower electrode 2 typically has a thickness of 100 nm to 1,000 nm.

(Photoelectric Conversion Layer)

In an embodiment, the photoelectric conversion layer 3 is a homojunction semiconductor layer of a p-type compound semiconductor layer 3a and an n-type compound semiconductor layer 3b. The compound semiconductor layer converts light into electricity. The p-type compound semiconductor layer 3a refers to a layer in a region of the photoelectric conversion layer 3 on the lower electrode 2. The n-type compound semiconductor layer 3b refers to a layer in a region of the photoelectric conversion layer 3 on the transparent electrode 4. The n-type compound semiconductor layer 3b is a layer in a region obtained by imparting n-type conductivity to a precursor for the photoelectric conversion layer 3 as a p-type semiconductor layer. Chalcopyrite compounds such as, for example, CIGS and CIT, containing a Group Ib element, a Group IIIB element, and a Group VIb element can be used as the compound semiconductor for the photoelectric conversion layer 3. Besides the chalcopyrite compounds, stannite compounds and kesterite compounds can be also used as the compound semiconductor for the photoelectric conversion layer 3. The chemical formulas which represent the compounds for the photoelectric conversion layer 3 include $Cu(Al_wIn_xGa_{1-w-x})(S_ySe_zTe_{1-y-z})_2$ and $Cu_2ZnSn(S_ySe_{1-y})_4$. The w, x, y, and z respectively meet $0 \leq w < 1$, $0 \leq x < 1$, $0 \leq y < 1$, $0 \leq z < 1$, $w + x \leq 1$ and $y + z < 1$.

The photoelectric conversion layer 3 typically has a thickness of 1000 nm to 3500 nm. More particularly, the p-type compound semiconductor layer 3a preferably has a film thickness of 1000 nm to 2500 nm, whereas the n-type compound semiconductor layer 3b preferably has a film thickness of 10 nm to 800 nm. The Group Ib element is preferably Cu. The Group IIIb element is preferably at least one element selected from the group consisting of Al, In, and Ga, and more preferably includes In. The Group VIb element is preferably at least one element selected from the group consisting of O, S, Se, and Te, and more preferably includes Se. In is more preferably used as the Group IIIb element because the use of In in combination with Ga makes it easy to adjust the band gap to the desired level. In addition, Te is more preferably used as the Group VIb element because of being likely to provide p-type semiconductor. As the photoelectric conversion layer 3, compound semiconductors can be used such as specifically, $Cu(In,Ga)(S,Se)_2$, $Cu(In,Ga)(Se,Te)_2$, $Cu(Al,Ga,In)Se_2$, or $Cu_2ZnSnS_4$, more specifically, $Cu(In,Ga)Se_2$, $CuInSe_2$, $CuInTe_2$, or $CuGaSe_2$. There is preferably, between the lower electrode 2 and the photoelectric conversion layer 3, a compound including the elements contained in the respective electrode and layer.

Due to the fact that the region thickness and pn interface vary depending on the doping process for imparting n-type conductivity, crystals of the p-type compound semiconductor and n-type compound semiconductor will be described below in regard to the vicinity of the lower electrode 2 or the vicinity of the transparent electrode 4. The vicinity of the lower electrode 2 refers to the photoelectric conversion layer 3 on the lower electrode 2. The vicinity of the transparent electrode 4 refers to the photoelectric conversion layer 3 on the side opposite to the lower electrode 2.

The photoelectric conversion layer 3 on the lower electrode 2 herein is defined as a region from the interface A between the lower electrode 2 and the photoelectric conversion layer 3 to 50 nm toward the photoelectric conversion layer 3, and the sizes of crystals at least partially included in the region are referred to as crystal grain sizes. In addition, the photoelectric conversion layer 3 on the side opposite to the lower electrode 2 is defined as a location from the interface B between the transparent electrode 4 and the photoelectric conversion layer 3 to 50 nm toward the photoelectric conversion layer 3, and the sizes of crystals in the location are referred to as crystal grain sizes. In the case of before forming the transparent electrode 4, the photoelectric conversion layer 3 on the side opposite to the lower electrode 2 refers to a region from the surface of the photoelectric conversion layer 3 on the side opposite to the lower electrode 2 to 50 nm toward the lower electrode 2. When the n-type region is thinner than 50 nm, the transparent electrode 4 and the vicinity region of the p-type compound semiconductor may be made thinner appropriately.

(Method for Producing Photoelectric Conversion Layer)

Next, a method for producing the photoelectric conversion layer 3 according to an embodiment will be described.

In an embodiment, the photoelectric conversion layer 3 is a layer obtained by forming a p-type semiconductor layer as a precursor therefor (a precursor for the photoelectric conversion layer) on the lower electrode 2, and imparting n-type conductivity to a region of the p-type semiconductor layer on the side with the transparent electrode 4 to be formed thereon. Methods for forming the p-type semiconductor layer include thin-film formation methods such as a vapor deposition method (three step method) and sputtering method, for forming a p-type semiconductor layer containing at least one of compound semiconductors of chalcopyrite compounds, stannite compounds, and kesterite compounds by depositing (first step) at least one selected from the Group IIIb elements and Group VIb elements on the lower electrode 2, then depositing (second step) at least one selected from the Group Ib elements and Group VIb elements, and then depositing (third step) at least one selected from the Group IIIb elements and Group VIb elements.

In particular, in the three-step method according to an embodiment, it is preferable to form a p-type semiconductor layer as a precursor for the photoelectric conversion layer 3 by depositing at least one selected from the Group IIIb elements and Group VIb elements (e.g., Ga or In as well as Se or S) on the lower electrode 2, then depositing at least one selected from (e.g., Cu and Se) selected from the Group Ib elements and Group VIb elements at high temperature, and thereafter again depositing at least one (e.g., Ga or In as well as Se or S) selected from the Group IIIb elements and Group VIb elements at low temperature through rapid cooling.

It is to be noted that while the following production method will be described with a vapor deposition method as an example, examples in the case of forming the photoelectric conversion layer 3 according to an embodiment by a sputtering method include, for example, a method of depositing at least one selected from the Group IIIb elements and Group VIb elements under a low-temperature condition for forming the region in the vicinity of the transparent electrode 4.

As for the precursor for the photoelectric conversion layer 3, preferably, the compound semiconductor on the lower electrode 2 is at least amorphous, or larger in average crystal grain size than on the side opposite to the lower electrode. In addition, as for the precursor for the photoelectric conversion layer 3, preferably, the compound semiconductor on the side opposite to the lower electrode 2 is at least amorphous, or smaller in average crystal grain size than on the lower electrode.

Hereinafter, the average crystal grain size of the compound semiconductor contained in the p-type compound semiconductor layer 3a or the precursor for the photoelectric conversion layer 3 on the lower electrode 2 is referred to as a p-layer average crystal grain size for descriptive purposes. In addition, the average crystal grain size of the compound semiconductor contained in the n-type compound semiconductor layer 3b or the precursor for the photoelectric conversion layer 3 on the side opposite to the lower electrode 2 is hereinafter referred to as an n-layer average crystal grain size for descriptive purposes.

It is preferable that the compound semiconductor in the precursor for the photoelectric conversion layer 3 on the lower electrode 2 or in the p-type compound semiconductor layer 3a be at least amorphous or large in grain size as crystals, because carriers are likely to transfer to increase the conversion efficiency. Thus, in the case of crystals, the p-layer average crystal grain size is 1000 nm to 3000 nm. The average crystal grain size of the p-type compound semiconductor is also preferably 1000 nm to 3000 nm. The p-layer average crystal grain size of 1500 nm or less is preferred in conversion efficiency, as photocarriers generated in the bulk can be prevented from being recombined before reaching the photoelectric conversion layer 3 and the transparent electrode 4, and furthermore the upper electrode 5. In addition, the p-layer average crystal grain size of 2500 nm or less is preferred in that the n-type conductivity is easily imparted as the diffusion of the n-type dopant is unlikely to be blocked in the process of forming the n-type compound semiconductor.

On the other hand, it is preferable that the compound semiconductor in the precursor for the photoelectric conversion layer 3 on the side opposite to the lower electrode 2 or in the n-type compound semiconductor layer 3b be amorphous or small in grain size as crystals, because the amount of light absorption in a long-wavelength region is increased in the p-type compound semiconductor layer 3a. It is preferable that the n-type compound semiconductor be small in grain size as crystals or amorphous, because incident light is scattered near the transparent electrode 4, mainly in the n-type compound semiconductor of the n-type compound semiconductor layer 3b to increase the optical path length, and thus increase long-wavelength light absorption in the p-type compound semiconductor layer 3a. For the reasons set forth above, in the case of crystals, the crystals which are small in grain size are more preferably 500 nm or less, even 200 nm or less in average crystal grain size. It is to be noted that the crystals which are small in grain size and amorphous component may be mixed in the precursor for the photoelectric conversion layer 3 on the side opposite to the lower electrode 2, or in the n-type compound semiconductor layer 3b in some cases.

In the vapor deposition method (three-step method), first, the lower electrode 2 such as Mo is formed by a method such as sputtering onto the substrate 1 composed of blue sheet glass or the like, and at least one selected from the Group IIIb elements such as In and Ga and the Group VIb elements such as Se is deposited (first step) onto the obtained lower electrode 2 (formed on the substrate 1) while the temperature is increased to 200°C to 400°C.

Thereafter, the deposition of at least one selected from the Group IIIb elements and Group VIb elements in the first step is heated to 450°C to 550°C, and at least one is deposited which is selected from the Group Ib elements such as Cu and the Group VIb elements such as Se. Because of a temperature decrease caused by an endothermic reaction in the deposition, the start of the temperature decrease is confirmed, and the deposition of the Group Ib element (e.g., Cu) is once stopped with a composition excessively including the Group Ib element (e.g., Cu) (second step).

Immediately after the deposition is stopped, the substrate temperature is lowered down to 400°C by rapidly cooling the deposition of at least one selected from the Group Ib elements and Group VIb elements in a natural way, or rapidly cooling the deposition through a jet of inert-gas such as nitrogen or argon from the side opposite to the lower electrode 2 (depositing direction). After the rapid cooling, at least one selected from the Group IIIb elements such as In or Ga and the Group VIb elements such as Se is again deposited (third step) to provide a composition somewhat excessively including the Group IIIb element such as In or Ga.

The precursor for the photoelectric conversion layer 3 on the lower electrode 2 has crystals increased in grain size because of the deposition at high temperature, the precursor for the photoelectric conversion layer 3 on the side opposite to the lower electrode 2 is small in grain size or amorphous, because of the rapid cooling after the completion of the deposition in the second step. In addition, the rapid cooling and deposition at low temperature in the third step will suppress the diffusion of the Group Ib element, for example, Cu, and the precursor for the photoelectric conversion layer 3 on the side opposite to the lower electrode 2 sill have more vacancies (e.g., Cu vacancies) of the Group Ib element, as compared with a case without rapid cooling. For example, it is preferable to apply n-type doping to a member with many Cu vacancies, because the penetration of many n-type dopants into Cu vacancy sites causes the member to function as an n-type semiconductor with many n-type dopants. After the formation of the p-type semiconductor layer, the p-type semiconductor layer can be partially changed from the p-type conductivity to n-type conductivity by immersing the precursor for the photoelectric conversion layer 3 from the side opposite to the lower electrode 2 in a liquid phase with the use of a solution (e.g., cadmium sulfate) containing an n-type dopant such as Cd and Zn.

The partial change of the p-type precursor for the photoelectric conversion layer 3 to n-type conductivity provides the homojunction photoelectric conversion layer 3 of the p-type compound semiconductor layer 3a and n-type compound semiconductor layer 3b joined to each other. In the case of doping with at least one element of Group IIa and Group IIb elements as n-type dopants, the process is carried out so that the side with the transparent electrode 4 to be formed has a higher n-type dopant concentration. After the doping with the n-type dopant, the next step is preferably carried out after cleaning and drying the dopant with water or the like. In the case of forming the n-type semiconductor layer 3b by a diffusion method with the use of an n-type dopant solution, the film formation temperature is preferably adapted to 0°C to 60°C, more preferably 10°C to 40°C, even on the order of room temperature (25°C) (20°C to 30°C). The excessively low temperatures of the solution and member to be processed fail to proceed with the doping to degrade the quality and diffusion rate of the n-type compound semiconductor layer 3b formed, whereas the excessively high temperatures thereof cause damage to the intended n-type compound semiconductor layer 3b. In an embodiment, it is possible to carry out the immersion step at 0°C to 60°C, and a simple apparatus can be thus used which requires no heating mechanism, cooling mechanism, or the like.

The immersion time in the solution containing the n-type dopant is preferably 1 minute to 60 minutes. The excessively short processing time insufficiently imparts n-type conductivity, whereas the excessively long processing time is not preferred for the reason of accelerated oxidation degradation of CIGS.

As the solution containing the n-type dopant of at least one of Group IIa and Group IIb elements, an ammonia solution is preferred. The dopant concentration in the ammonia solution can be increased, because the process for imparting n-type conductivity is carried out at 50°C or lower. Specifically, when the dopant solution is 50°C or lower, the dopant concentration in the dopant solution can be adapted to 80 mM or higher. The case of imparting n-type conductivity under a heating condition is disadvantageous from the perspective of doping, because the dopant concentration in the dopant solution is unable to be increased to 0.8 mM or higher. From the perspective of increasing the dopant concentration in the dopant solution, the process for imparting n-type conductivity is more preferably carried out at 30°C or lower.

The average crystal grain size of the photoelectric conversion layer 3 can be acquired from a cross-sectional TEM image of the photoelectric conversion device. For obtaining the cross sectional image, the image can be confirmed by TEM (Transmission Electron Microscope) observation of the section. The same measurement can be also applied to the member with the precursor for the photoelectric conversion layer 3 in the process of preparing a photoelectric conversion device, etc. Crystals are observed in an observation image of 4 $\mu$m in width by TEM observation of the p-type compound semiconductor layer 3a at 40,000-fold magnification around 50 nm from the interface A between the layer and the lower electrode 2. From the area for each crystal, the diameter of the perfect circle corresponding to the area is calculated. This diameter is regarded as the crystal grain size to calculate the p-type average crystal grain size. In addition, likewise, the n-type average crystal grain size is calculated in an observation image of 4 $\mu$m in width by cross-sectional TEM observation of the n-type compound semiconductor layer 3b around 50 nm from the interface B between the layer and the transparent electrode 4. It is to be noted that there may be only ends of the crystals in the cross-sectional TEM image, where the sizes of the crystals themselves are not reflected in some cases. Thus, the crystals of less than 1/10 of the median value among the calculated crystal diameters are excluded from the calculation of the average crystal grain size.

Furthermore, whether the photoelectric conversion layer 3 on the lower electrode 2 and the photoelectric conversion layer 3 on the side opposite to the lower electrode 2 are amorphous or not can be confirmed by electron beam diffraction. The crystallinity can be determined from the fact that a crystal layer results in the form of a spot, whereas an amorphous layer results in the form of a ring in terms of electron beam diffraction.

As just described, the method for producing the photoelectric conversion layer 3 according to an embodiment essentially requires no heating, cooling, or stirring mechanism for the doping, or holder as a fixing instrument for fixing a member with a photoelectric conversion layer in the immersion, and can reduce the amount of the solution and chemicals used to one-several hundredth to one-several tenths of the conventional amount.

(Transparent electrode)

In an embodiment, the transparent electrode 4 refers to a film that is transparent to light such as sunlight, and electrically conductive. For example, Al, B, Ga, or the like can be used for the transparent electrode 4. The transparent electrode 4 can be formed as a film by sputtering, chemical vapor deposition (Chemical Vapor Deposition: CVD) or the like. Further, i-ZnO on the order of, for example, 10 nm to 100 nm in thickness may be formed as a semi-insulating layer between the transparent electrode 4 and the photoelectric conversion layer 3. The semi-insulating layer refers to a layer including particles of an oxide containing at least one one element of Zn, Ti, In, and Mg. For example, particles of an oxide containing Zn and Mg elements are represented by $Zn_{1-x}Mg_xO$ (0 < x < 1). The oxide particles preferably have an average primary particle size of 1 nm to 40 nm. In addition, the layer is desirably transparent and small in sunlight absorption loss, because of being located above the photoelectric conversion layer. Further, CdS on the order of, for example, 1 nm to 10 nm in thickness may be formed as a contact layer between the semi-insulating layer and the photoelectric conversion layer 3. This serves to fill a deficiency of Group VI element in the photoelectric conversion layer, and improves the open circuit voltage. In addition, the CdS has almost no light absorption loss, because of the extremely small film thickness.

Further, a window layer may be provided between the transparent electrode 4 and the photoelectric conversion layer 3.

(Window Layer)

The window layer according to an embodiment is an i-type high-resistance (semi-insulating) layer provided between the transparent electrode 4 and the photoelectric conversion layer 3. The window layer is a layer containing any compound of ZnO, MgO, $(Zn_aMg_{1-a})O$, $InGa_bZn_aO_c$, SnO, $InSn_dO_c$, $TiO_2$, $ZrO_2$, or composed of one or more compounds thereof. The a, b, c, and d preferably meet $0 < a < 1$, $0 < b < 1$, $0 < c < 1$, and $0 < d < 1$, respectively. The provision of the high-resistance layer between the transparent electrode 4 and the photoelectric conversion layer 3 has the advantage of reducing the leakage current from the n-type compound semiconductor layer 3b to the transparent electrode 4 to improve the conversion efficiency. The window layer is preferably not excessively thick, because the compound constituting the window layer contains a high-resistance compound. Alternatively, when the window layer is excessively thin in film thickness, the effect of reducing the leakage current will be substantially lost. Accordingly, the preferred film thickness of the window layer is 5 nm to 100 nm on average.

Methods for forming the window layer include CVD methods, spin coating methods, dip methods, deposition methods, and sputtering methods. The CVD methods provide an oxide thin film for the window layer in the following way. The oxide thin film is obtained by introducing, into a chamber, a member after the formation of the photoelectric conversion layers 3, heating the member, and further introducing an organometallic compound containing at least one of Zn, Mg, In, Ga, Sn, Ti, and Zr, water, etc. into the chamber to cause a reaction on the n-type compound semiconductor layer 3b. The spin coating methods provide an oxide thin film for the window layer in the following way. A solution containing a organometallic compound or oxide particles containing at least one of Zn, Mg, In, Ga, Sn, Ti, and Zr is applied by spin coating onto a member after the formation of the photoelectric conversion layers 3. After the application, the solution is heated by a dryer or reacted to obtain an oxide thin film. The dipping methods provide an oxide thin film for the window layer in the following way. The n-type compound semiconductor layer side of a member after the formation of the photoelectric conversion layers 3 is dipped in the same solution as in the spin coating methods. After the required time, the member is pulled up from the solution. After pulling up, the solution on the member is heated or reacted to obtain an oxide thin film. The deposition methods provide a compound thin film for the window layer in the following way. In the methods, a window layer material is sublimated by resistance heating, laser irradiation, or the like to obtain an oxide thin film. The sputtering methods refer to methods in which a target is irradiated with plasma to obtain a window layer. Among the CVD methods, spin coating methods, dipping methods, deposition methods, sputtering methods, the spin coating methods and the dipping methods are film formation methods which cause less damage to the photoelectric conversion layer 3, and preferred preparation methods from the perspective of increase in efficiency, in that the methods will not cause the photoelectric conversion layer 3 to produce any recombination center.

(Interlayer)

In an embodiment, an interlayer is a compound thin film layer provided between the photoelectric conversion layer 3 and the transparent electrode 4, or between the photoelectric conversion layer 3 and the window layer. In an embodiment, a photoelectric conversion device is preferred which includes the interlayer, but the interlayer may be omitted. The interlayer is a thin film containing any compound of ZnS, $Zn(O_\alpha S_{1-\alpha})$, $(Zn_\beta Mg_{1-\beta})(O_\alpha S_{1-\alpha})$, $(Zn_\beta Cd_\gamma Mg_{1-\beta-\gamma})$ $(O_\alpha S_{1-\alpha})$, CdS, Cd $(O_\alpha S_{1-\alpha})$, $(Cd_\beta Mg_{1-\beta})S$, $(Cd_\beta Mg_{1-\beta})(O_\alpha S_{1-\alpha})$ $In_2S_3$, $In_2(O_\alpha S_{1-\alpha})$, CaS, $Ca(O_\alpha S_{1-\alpha})$, SrS, $Sr(O_\alpha S_{1-\alpha})$, ZnSe, $ZnIn_{2-\delta}Se_{4-\epsilon}$, ZnTe, CdTe, and Si ($\alpha$, $\beta$, $\gamma$, $\delta$, and $\epsilon$ preferably meet $0 < \alpha < 1$, $0 < \beta < 1$, $0 < \gamma < 1$, $0 < \delta < 2$, $0 < \epsilon < 4$, and $\beta + \gamma < 1$, respectively), or composed of one or more compounds thereof. The interlayer may have the form of covering only some of the surface of the n-type compound semiconductor layer 3b on the transparent electrode 4. For example, the interlayer only has to cover 50% of the surface of the n-type compound semiconductor layer 3b on the transparent electrode 4. From the perspective of environmental issues, it is preferable to use a compound containing no Cd for the interlayer. The interlayer volume resistivity of 1 $\Omega$cm or more has the advantage of making it possible to suppress leakage current derived from low-resistance components which can be present in the p-type photoelectric conversion layer. Further, the formation of an interlayer containing S can dope the n-type compound semiconductor layer 3b with the S contained in the interlayer.

With the interlayer, the conversion efficiency can be improved for the photoelectric conversion device including the homojunction photoelectric conversion layer. With the interlayer, the open circuit voltage can be increased to improve the conversion efficiency for the photoelectric conversion device including the photoelectric conversion layer 3 of homojunction structure. The role of the interlayer is lowering the contact resistance between the n-type compound semiconductor layer 3b and the transparent electrode 4. The detailed reason for lowering the contact resistance remains under scrutiny. For example, the interlayer is believed to serve as a transition layer between the n-type compound semiconductor layer 3b and the transparent electrode 4, and act in the direction of reducing discontinuity between the energy bands of the n-type compound semiconductor layer 3b and transparent electrode 4 to lower the contact resistance.

From the perspective of improvement in conversion efficiency, the interlayer preferably has an average film thickness of 1 nm to 10 nm. The average film thickness of the interlayer is obtained from a cross-sectional image of the photoelectric conversion device. When the photoelectric conversion layer 3 is a heterojunction-type layer, a CdS layer of several tens nm or more, such as, for example, 50 nm in thickness is required as the buffer layer, and as the interlayer, a thinner film is provided on the n-type compound semiconductor layer 3b. In the case of the photoelectric conversion device including the heterojunction photoelectric conversion layer, the film thickness comparable to the interlayer according to an embodiment is not preferred, because the conversion efficiency is decreased.

The interlayer is preferably a hard film from the perspective of improvement in conversion efficiency, and any method of solution growth (Chemical Bath Deposition: CBD) methods, CVD methods, and physical vapor deposition (Physical Vapor Deposition: PVD) methods is preferred as the method for forming the hard film. The interlayer may be an oxide film as long as the film is a hard film. It is to be noted that the hard film means a high-density compact film. When the n-type compound semiconductor layer 3b is damaged during the formation of the interlayer, surface recombination centers are formed, and thus, from perspective of low-damage film formation, the method for forming the interlayer is preferably a CBD method among the methods mentioned above. For the creation of a thin film such as from 1 nm to 10 nm, the film growth time may be shortened depending on the thickness. For example, under the film formation condition with the reaction time of 420 seconds, which is required for growing an interlayer of 60 nm by a CBE method, the reaction time may be adapted to 35 seconds in the case of forming an interlayer of, for example, 5 nm. As a method for adjusting the film thickness, it is also possible to alter the concentration of the prepared solution.

(Upper electrode)

In an embodiment, the upper electrode 5, which is an electrode of the photoelectric conversion device, is a metal film formed on the transparent electrode 4. For example, Al, Ag, or Au can be used as the upper electrode 5. Furthermore, in order to improve the adhesion to the transparent electrode 4, for example, Al, Ag, or Au may be provided on a deposited film of Ni or Cr. The upper electrode 5 typically has a thickness of 200 nm to 2,000 nm. The upper electrode 5 can be deposited by, for example, a resistance heating vapor deposition method. It is to be noted that when the transparent electrode 4 is low in sheet resistance, and when the series resistance is negligibly low with respect to the differential resistance of the photoelectric conversion layer 3, the upper electrode 5 can be omitted.

(Anti-reflection film)

In an embodiment, the anti-reflection film 6, which is a film provided to facilitate the introduction of light into the photoelectric conversion layer 3, is formed on the transparent electrode 4. It is desirable to use, for example, $MgF_2$ as the anti-reflection film 6. The anti-reflection film 6 typically has a thickness of 90 nm to 120 nm. The anti-reflection film 6 can be formed by, for example, an electron beam evaporation method.

Hereinafter, the present disclosure will be more specifically described with reference to examples.

(Example 1)

With the use of a blue sheet glass as the substrate 1, a Mo thin film on the order of 700 nm to serve as the lower electrode 2 is deposited thereon by a sputtering method. The sputtering was carried out by applying RF 200 W in an Ar gas atmosphere with Mo as a target. After the deposition of the Mo thin film to serve as the lower electrode 2, a $Cu(In,Ga)Se_2$ thin film to serve as a precursor for the photoelectric conversion layer 3 was deposited by a vapor deposition method (three-step method). First, the substrate temperature is increased to 300°C, and In, Ga, and Se are deposited (first step). Thereafter, the substrate temperature is increased to 500°C, and Cu and Se are deposited. The initiation of an endothermic reaction is confirmed, and the deposition of Cu is stopped once on reaching a composition with excessive Cu (second step). Immediately after stopping the deposition, the substrate was rapidly cooled in a natural way to lower the substrate temperature down to 400°C. After the rapid cooling, In, Ga, and Se are again deposited (third step) to provide a composition with slightly excessive Group IIIb element such as In or Ga. The film thickness of the precursor for the photoelectric conversion layer 3 was adjusted to on the order of 2500 nm, whereas the film thickness of the layer which is small in grain size was adjusted to on the order of 200 nm. The compound semiconductor in the precursor for the photoelectric conversion layer 3 on the lower electrode 2 was 1000 nm in average grain size. In addition, the compound semiconductor in the precursor for the photoelectric conversion layer 3 on the side opposite to the lower electrode 2 was 300 nm in average grain size.

In order to make the obtained precursor for the photoelectric conversion layer 3 partially n-type, the member after the deposition of the precursor for the photoelectric conversion layer 3 was immersed in a 25% ammonia solution with 0.8 mM to 80 mM cadmium sulfate dissolved therein from the precursor for the photoelectric conversion layer 3 on the side opposite to the lower electrode 2, and reacted at room temperature (25°C) for 22 to 60 minutes. Thus, the n-type compound semiconductor layer 3b is formed which is doped with Cd to a depth on the order of 100 nm in a direction toward the lower electrode from the surface of the photoelectric conversion layer 3 on the side opposite to the lower electrode 2. On the n-type compound semiconductor layer 3b, an ultrathin CdS layer as the interlayer was formed by a CBD method, and an i-ZnO thin film as the semi-insulating layer was deposited by spin coating. Subsequently, ZnO : Al containing 2 wt% of alumina ($Al_2O_3$) to serve as the transparent electrode 4 was deposited on the order of 1 $\mu$m on

the semi-insulating layer. Furthermore, as the upper electrode 5, Al was deposited by resistance heating. The film thickness was adjusted to on the order of 300 nm. Finally, as the anti-reflection film 6, $MgF_2$ was deposited on the order of 105 nm by an electron beam evaporation method. Alternatively, microlens from OPTMATE Corporation was attached as the anti-reflection film 6. As a result, the photoelectric conversion device 100 according to an embodiment was obtained. Under quasi-sunlight irradiation of AM1.5 through a solar simulator, a voltage source and a multimeter were used to measure the open circuit voltage (Voc), short-circuit current density (Jsc), and fill factor FF, and figure out the conversion efficiency ($\eta$). Twenty-seven similar samples were prepared which were varied in the concentration of the reaction solution and the reaction time. The average efficiency was 16.8%.

(Comparative Example (Reference Example) 1)

The precursor for the photoelectric conversion layer 3 was prepared in the same way as in Example 1. In order to make the obtained precursor for the photoelectric conversion layer 3 partially n-type, the member after the deposition of the precursor for the photoelectric conversion layer 3 was immersed in a 2.5% ammonia solution with 0.8 mM cadmium sulfate dissolved therein from the precursor for the photoelectric conversion layer 3 on the side opposite to the lower electrode 2, and reacted at 80°C for 22 to 90 minutes. Thus, the n-type compound semiconductor layer 3b is formed which is doped with Cd to a depth on the order of 100 nm in a direction toward the lower electrode from the surface of the photoelectric conversion layer 3 on the side opposite to the lower electrode 2. In the subsequent step, the elements up to the anti-reflection film 6 were prepared in the same way as in Example 1, thereby preparing the photoelectric conversion device 100 according to an embodiment. Under quasi-sunlight irradiation of AM1.5 through a solar simulator, a voltage source and a multimeter were used to measure the open circuit voltage (Voc), short-circuit current density (Jsc), and fill factor FF, and figure out the conversion efficiency ($\eta$). Twenty-six similar samples were prepared which were varied in the concentration of the reaction solution and the reaction time. The average efficiency was 15.9%.

(Example 2)

The precursor for the photoelectric conversion layer 3 was prepared in the same way as in Example 1. In order to make the obtained precursor for the photoelectric conversion layer 3 partially n-type, the member after the deposition of the precursor for the photoelectric conversion layer 3 was immersed in a 25% ammonia solution with 80 mM zinc sulfate dissolved therein from the precursor for the photoelectric conversion layer 3 on the side opposite to the rear electrode 2, and reacted at 25°C for 22 minutes. Thus, the n-type semiconductor layer 3b is formed which is doped with zinc to a depth on the order of 100 nm in a direction toward the lower electrode from surface of the photoelectric conversion layer 3 on the side opposite to the rear electrode 2. In the subsequent step, except for containing no CdS contact layer, the elements up to the anti-reflection film 6 were prepared in the same way as in Example 1, thereby preparing the photoelectric conversion device 100 according to an embodiment. Under quasi-sunlight irradiation of AM1.5 through a solar simulator, a voltage source and a multimeter were used to measure the open circuit voltage (Voc), short-circuit current density (Jsc), and fill factor FF, and figure out the conversion efficiency ($\eta$). The efficiency was 11.0%.

(Comparative Example (Reference Example) 2)

The precursor for the photoelectric conversion layer 3 was prepared in the same way as in Example 1. In order to make the obtained precursor for the photoelectric conversion layer 3 partially n-type, the member after the deposition of the precursor for the photoelectric conversion layer 3 was immersed in a 2.5% ammonia solution with 0.8 mM zinc sulfate dissolved therein from the precursor for the photoelectric conversion layer 3 on the side opposite to the lower electrode 2, and reacted at 80°C for 22 minutes. Thus, the n-type semiconductor layer 3b is formed which is doped with zinc to a depth on the order of 100 nm in a direction toward the lower electrode from surface of the photoelectric conversion layer 3 on the side opposite to the lower electrode 2. In the subsequent step, except for containing no CdS contact layer, the elements up to the anti-reflection film 6 were prepared in the same way as in Example 1, thereby preparing the photoelectric conversion device 100 according to an embodiment. Under quasi-sunlight irradiation of AM1.5 through a solar simulator, a voltage source and a multimeter were used to measure the open circuit voltage (Voc), short-circuit current density (Jsc), and fill factor FF, and figure out the conversion efficiency ($\eta$). The efficiency was 3.8%.

(Example 3)

Except that the film formation temperature was adjusted to room temperature in the third step after the rapid cooling in the film formation from the precursor for the photoelectric conversion layer 3, for making the n-type compound semiconductor layer 3b amorphous, an photoelectric conversion device was prepared in the same way as in Example 1. The compound semiconductor the photoelectric conversion layer 3 on the lower electrode 2 was 1000 nm in average grain size. As a result, the photoelectric conversion device 100 according to an embodiment was obtained. The efficiency was 14.5%.

(Comparative Example (Reference Example) 3)

Except that the precursor for the photoelectric conversion layer 3 was composed of the same crystal grains both on the lower electrode 2 and on the side opposite thereto, without carrying out the rapid cooling in the film formation from the precursor for the photoelectric conversion layer 3, and immersed in a 2.5% ammonia solution with 0.8 mM cadmium sulfate dissolved therein, and reacted at 80°C for 22 minutes, a photoelectric conversion device was prepared in the same way as in Example 1. The compound semiconductor the photoelectric conversion layer 3 on the lower electrode 2 was 2500 nm in average grain size. In addition, the compound semiconductor in the photoelectric conversion layer 3 on the side opposite to the lower electrode 2 was 2500 nm in average grain size. More specifically, the layer is composed of one type of grain entirely from bottom to top. No amorphous compound semiconductor was confirmed in the photoelectric conversion layer 3 on the side opposite to the lower electrode 2. As a result, the photoelectric conversion device 100 according to an embodiment was obtained. The efficiency was 8.0%.

(Example 4)

The precursor for the photoelectric conversion layer 3 was prepared in the same way as in Example 1. Except that, in order to make the obtained precursor for the photoelectric conversion layer 3 partially n-type, the member after the deposition of the precursor for the photoelectric conversion layer 3 was immersed in a 2.5% ammonia solution with 0.8 mM cadmium sulfate dissolved therein from the precursor for the photoelectric conversion layer 3 on the side opposite to the lower electrode 2, and reacted at 60°C for 3 minutes, an photoelectric conversion element was prepared in the same way as in Example 1. As a result, the photoelectric conversion device 100 according to an embodiment was obtained. The efficiency was 15.9%.

(Example 5)

The precursor for the photoelectric conversion layer 3 was prepared in the same way as in Example 1. In order to make the obtained precursor for the photoelectric conversion layer 3 partially n-type, the member after the deposition of the precursor for the photoelectric conversion layer 3 was immersed in a 25% ammonia solution with 0.8 mM to 80 mM cadmium sulfate dissolved therein from the precursor for the photoelectric conversion layer 3 on the side opposite to the lower electrode 2, and reacted at room temperature (25°C) for 22 to 60 minutes. Thus, the n-type compound semiconductor layer 3b is formed which is doped with Cd to a depth on the order of 100 nm in a direction toward the lower electrode from surface of the photoelectric conversion layer 3 on the side opposite to the lower electrode 2. Thereafter, the photoluminescence intensity was immediately measured. In addition, the photoluminescence intensity was also measured on a sample subjected to no doping process from the same lot, and the intensity ratio was calculated between the photoluminescence intensity of the sample subjected to the doping process and the photoluminescence intensity of the sample subjected to no doping process. Forty-one similar samples were prepared which were varied in the concentration of the reaction solution and the reaction time. The average value was 1.110 for the relative PL intensity obtained.

(Comparative Example (Reference Example) 4)

The precursor for the photoelectric conversion layer 3 was prepared in the same way as in Comparative Example 1. In order to make the obtained precursor for the photoelectric conversion layer 3 partially n-type, the member after the deposition of the precursor for the photoelectric conversion layer 3 was immersed in a 2.5% ammonia solution with 0.8 mM cadmium sulfate dissolved therein from the precursor for the photoelectric conversion layer 3 on the side opposite to the lower electrode 2, and reacted at 80°C for 22 to 90 minutes. Thus, the n-type compound semiconductor layer 3b is formed which is doped with Cd to a depth on the order of 100 nm in a direction toward the lower electrode from the surface of the photoelectric conversion layer 3 on the side opposite to the lower electrode 2. Thereafter, the photoluminescence intensity was immediately measured. In addition, the photoluminescence intensity was also measured on a sample subjected to no doping process from the same lot, and the intensity ratio was calculated (relative PL intensity) between the photoluminescence intensity of the sample subjected to the doping process and the photoluminescence intensity of the sample subjected to no doping process. Thirty-six similar samples were prepared which were varied in the concentration of the reaction solution and the reaction time. The average value was 0.752 for the relative PL intensity obtained.

(Example 6)

With the use of a blue sheet glass as the substrate 1, a Mo thin film on the order of 700 nm to serve as the rear electrode 2 is deposited thereon by a sputtering method. The sputtering was carried out by applying RF 200 W in an Ar gas atmosphere with Mo as a target. After the deposition of the Mo thin film to serve as the rear electrode 2, a $Cu(Al,Ga)Se_2$ thin film to serve as a precursor for the photoelectric conversion layer 3 was deposited by a vapor deposition method (three-step method). First, the substrate temperature is increased to 300°C, and Al, Ga, and Se are deposited (first step). Thereafter, the substrate temperature is increased to 520°C, and Cu and Se are deposited. The initiation of an endothermic reaction is confirmed, and the deposition of Cu is stopped once on reaching a composition with excessive Cu (second step). Immediately after stopping the deposition, the substrate was rapidly cooled in a natural way to lower the substrate temperature down to 400°C. After the rapid cooling, Al, Ga, and Se are again deposited (third step) to provide a composition with slightly excessive Group IIIb element such as Al or Ga. The film thickness of the precursor for the photoelectric conversion layer 3 was adjusted to on the order of 2500 nm, whereas the film thickness of the layer which is small in grain size was adjusted to on the order of 200 nm. The compound semiconductor in the precursor for the photoelectric conversion layer 3 on the rear electrode 2 was 1000 nm in average grain size. In addition, the compound semiconductor in the precursor for the photoelectric conversion layer 3 on the side opposite to the rear electrode 2 was 300 nm in average grain size.

In order to make the obtained precursor for the photoelectric conversion layer 3 partially n-type, the member after the deposition of the precursor for the photoelectric conversion layer 3 was immersed in a 25% ammonia solution with 0.8 mM to 80 mM cadmium sulfate dissolved therein from the precursor for the photoelectric conversion layer 3 on the side opposite to the rear electrode 2, and reacted at room temperature (25°C) for 22 minutes. Thus, the n-type compound semiconductor layer 3b is formed which is doped with Cd to a depth on the order of 100 nm in a direction toward the rear electrode from surface of the photoelectric conversion layer 3 on the side opposite to the rear electrode 2. On this layer, an i-ZnO thin film as the semi-insulating layer was deposited by spin coating. Subsequently, ZnO : Al containing 2 wt% of alumina ($Al_2O_3$) to serve as the transparent electrode 4 was deposited on the order of 1 $\mu$m on the semi-insulating layer. Furthermore, as the upper electrode 5, Al was deposited by resistance heating. The film thickness was adjusted to on the order of 300 nm. Finally, microlens from OPTMATE Corporation was attached as the anti-reflection film 6. As a result, the photoelectric conversion device 100 according to an embodiment was obtained. Under quasi-sunlight irradiation of AM1.5 through a solar simulator, a voltage source and a multimeter were used to measure the open circuit voltage (Voc), short-circuit current density (Jsc), and fill factor FF, and figure out the conversion efficiency ($\eta$). The efficiency was 6.0%.

(Comparative Example (Reference Example) 5)

With the use of a blue sheet glass as the substrate 1, a Mo thin film on the order of 700 nm to serve as the rear electrode 2 is deposited thereon by a sputtering method. The sputtering was carried out by applying RF 200 W in an Ar gas atmosphere with Mo as a target. After the deposition of the Mo thin film to serve as the rear electrode 2, a $Cu(Al,Ga)Se_2$ thin film to serve as a precursor for the photoelectric conversion layer 3 was deposited by a vapor deposition method (three-step method). First, the substrate temperature is increased to 380°C, and Al, Ga, and Se are deposited (first step). Thereafter, the substrate temperature is increased to 550°C, and Cu and Se are deposited. The initiation of an endothermic reaction is confirmed, and the deposition of Cu is stopped once on reaching a composition with excessive Cu (second step). After three minutes, Al, Ga, and Se are again deposited (third step) to provide a composition with slightly excessive Group IIIb element such as Al or Ga. The film thickness of the precursor for the photoelectric conversion layer 3 was adjusted to on the order of 2000 nm, whereas the compound semiconductor in the precursor for the photoelectric conversion layer 3 on the rear electrode 2 was on the order of 2000 nm in grain size, and the precursor is even uniformly composed up to the transparent electrode side.

In order to make the obtained precursor for the photoelectric conversion layer 3 partially n-type, the member after the deposition of the precursor for the photoelectric conversion layer 3 was immersed in a 25% ammonia solution with 0.8 mM to 80 mM cadmium sulfate dissolved therein from the precursor for the photoelectric conversion layer 3 on the side opposite to the rear electrode 2, and reacted at room temperature (25°C) for 22 minutes. However, the n-type compound semiconductor layer 3b was not formed, without being doped with Cd in a direction toward the rear electrode from the surface of the photoelectric conversion layer 3 on the side opposite to the rear electrode 2. On this layer, an i-ZnO thin film as the semi-insulating layer was deposited by spin coating. Subsequently, ZnO : Al containing 2 wt% of alumina ($Al_2O_3$) to serve as the transparent electrode 4 was deposited on the order of 1 $\mu$m on the semi-insulating layer. Furthermore, as the upper electrode 5, Al was deposited by resistance heating. The film thickness was adjusted to on the order of 300 nm. Finally, microlens from OPTMATE Corporation was attached as the anti-reflection film 6. As a result, the photoelectric conversion device 100 according to an embodiment was obtained. Under quasi-sunlight irradiation of AM1.5 through a solar simulator, a voltage source and a multimeter were used to measure the open circuit voltage (Voc), short-circuit current density (Jsc), and fill factor FF, and figure out the conversion efficiency ($\eta$). The efficiency was 0.8%.

Example 1 and Comparative Example 1 refer to examples of focusing attention on the conversion efficiencies of the photoelectric conversion devices which differ in cadmium doping temperature (25°C, 80°C). In comparison between 25°C and 80°C, it is clear that the doping at 25°C results in a higher conversion efficiency of 16.8% on average. In contrast, the photoelectric conversion device doped at 80°C has an efficiency of 15.9% on average. This is believed to be due to the fact that the photoelectric conversion layer is oxidized and deteriorated at the high temperature of 80°C to produce an increase in recombination center. In addition, it is due to the fact that the doping at 80°C produces a white precipitate (CdO or the like) and interferes with the doping at the cadmium sulfate concentration of 0.8 mM or more.

Example 1, Comparative Example 1, and Comparative Example 4 refer to examples of focusing attention on the conversion efficiencies of the photoelectric conversion devices which differ in cadmium doping temperature (25°C, 80°C, 60°C). In comparison between 25°C and 80°C, it is clear that the doping at 25°C results in a higher open circuit voltage of 624 mV on average. In contrast, the photoelectric conversion device doped at 80°C has an open circuit voltage of 608 mV on average. This result indicates that the decrease in photoelectric conversion is caused by the decrease in open circuit voltage, which is a result that supports that the photoelectric conversion layer is oxidized and deteriorated at the high temperature of 80°C to produce an increase in recombination center. Example 7 including the doping at 60°C for 3 minutes, which resulted in 627 mV, favorably compares with the doping at 25°C, and indicates that the deterioration of the photoelectric conversion layer 3 is advanced by doping for a long period of time at high temperature on the order of 80°C. In addition, in the case of Example 7, the relative PL intensity of 1.142 also supports this indication.

Example 3 and Comparative Example 2 refer to examples of focusing attention on the conversion efficiencies of the photoelectric conversion devices which differ in zinc doping temperature (25°C, 80°C). In comparison between 25°C and 80°C, it is clear that the doping at 25°C results in a higher conversion efficiency. This is a result that supports that in the case of doping with zinc, the photoelectric conversion layer is also oxidized and deteriorated at the high temperature of 80°C to produce an increase in recombination center.

Example 2 and Comparative Examples 1 and 3 refer to examples of focusing attention on the conversion efficiencies of the photoelectric conversion devices which differ in the photoelectric conversion layer 3 on the side opposite to the lower electrode 2. While the efficiency is 14.5% or 15.9% (average) when the photoelectric conversion layer 3 on the side opposite to the lower electrode 2 is amorphous or on the order of 200 nm in grain size, the efficiency is low with 8.0% when the precursor for the photoelectric conversion layer 3 on the lower electrode 2 and on the side opposite thereto is large in grain size. This indicates that it is important that for the doping, the precursor for the photoelectric conversion layer 3 on the side opposite to the rear electrode 2 be smaller in grain size than the precursor for the photoelectric conversion layer 3 on the lower electrode 2.

Example 5 and Comparative Example 4 refer to examples of focusing attention on the photoluminescence intensities of the photoelectric conversion layers which differ in doping temperature (25°C, 80°C). In comparison between 25°C and 80°C, the doping at 25°C is higher in relative PL intensity, with an average value of 1.110. This is because the Cu deficient sites to be doped are filled with the dopant, and believed to be increased from the unprocessed case. In contrast, the photoelectric conversion layer doped at 80°C has an average value of 0.752, which is smaller than 1, which indicates that in conjunction with the progress of the doping, the photoelectric conversion layer is oxidized and deteriorated to produce an increase in recombination center. This result indicates that the decrease in conversion efficiency is caused by the increase in recombination center, that is, the decreased in open circuit voltage, which is a result that supports that the doping at room temperature is effective.

Example 6 and Comparative Example 5 refer to examples of focusing attention on the average crystal grain size of the precursor for the photoelectric conversion layer 3. Example 7 with the average crystal grain size of the precursor for the photoelectric conversion layer 3 within the scope of the present disclosure is higher in efficiency, as compared with Comparative Example 4 with the average crystal grain size uniform. This indicates that it is important that for the doping, the precursor for the photoelectric conversion layer 3 on the side opposite to the rear electrode 2 be smaller in grain size than the precursor for the photoelectric conversion layer 3 on the lower electrode 2.

In this specification, some of the elements are represented by only chemical symbols for the elements.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

**Claims**

1. A method for manufacturing a photoelectric conversion device, comprising: forming, on a first electrode, a photoelectric conversion layer comprising at least one of a chalcopyrite compound, a stannite compound, and a kesterite compound,

   wherein the forming of the photoelectric conversion layer includes forming a photoelectric conversion layer precursor comprising at least one compound semiconductor of a chalcopyrite compound, a stannite compound, and a kesterite compound on the first electrode, and

   immersing the precursor in a liquid including at least one of Group IIa and Group IIb elements at 0°C to 60°C, after forming of the photoelectric conversion layer precursor, and

   wherein the compound semiconductor on a side of the first electrode is at least either amorphous or larger in average crystal grain size than the compound semiconductor on an opposite side of the first electrode.

2. The method according to claim 1, wherein a process is carried out for making the compound semiconductor on the first electrode larger in average crystal grain size than on the side opposite to the first electrode in the forming of photoelectric conversion layer precursor.

3. The method according to claim 1 or 2, wherein the compound semiconductor is at least either 500 nm or less in average crystal grain size on the side opposite to the first electrode, or amorphous.

4. The method according to any one of the preceding claims, wherein the compound semiconductor is 1000 nm to 3000 nm in average crystal grain size on the first electrode.

5. The method according to any one of the preceding claims, wherein at least one selected from Group IIIb elements and Group VIb elements is deposited while a member comprising the first electrode is heated to 200°C to 400°C, then, at least one selected from Group Ib elements and Group VIb elements is deposited while the temperature is increased to 450°C to 550°C, and

   then, while cooling down to 400°C or less, at least one selected from Group IIIb elements and Group VIb elements is deposited to form the photoelectric conversion layer precursor comprising at least one compound semiconductor of a chalcopyrite compound, a stannite compound, and a kesterite compound.

6. The method according to any one of the preceding claims, wherein a second electrode is formed on a surface of the photoelectric conversion layer on the side opposite to the first electrode, after the forming of the photoelectric conversion layer.

7. The method according to any one of the preceding claims, wherein the liquid including the at least one of Group IIa and Group IIb elements is a dopant solution of 80 mM or higher.

8. The method according to any one of the preceding claims, wherein the opposite side of the first electrode of the photoelectric conversion layer precursor is immersed in the immersing of the precursor.

Fig.1

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2013196115 A